Europäisches Patentamt

European Patent Office

Office européen des brevets

(11) Numéro de publication: **0 499 805 A1**

# DEMANDE DE BREVET EUROPEEN

(21) Numéro de dépôt: **92100878.5**

(22) Date de dépôt: **20.01.92**

(51) Int. Cl.5: **C23C 14/28**, C23C 14/54

(30) Priorité: **24.01.91 LU 87880**

(43) Date de publication de la demande:
**26.08.92 Bulletin 92/35**

(84) Etats contractants désignés:
**AT BE CH DE DK ES FR GB GR IT LI LU NL PT SE**

(71) Demandeur: **COMMUNAUTE ECONOMIOUE EUROPEENNE (CEE)**
**Bâtiment Jean Monnet Plateau du Kirchberg**
**L-2920 Luxembourg(LU)**

(72) Inventeur: **Grossetie, Jean Claude**
**Via del Lupo, 9**
**I-21027 Ispra (VA)(IT)**

Inventeur: **Miehe, Joseph-Albert**
**9, rue Curie**
**F-67200 Strasbourg(FR)**
Inventeur: **Heisel, Francine**
**26, rue du Champ de Manoeuvre**
**F-67200 Strasbourg(FR)**
Inventeur: **Fogarassy, Eric**
**42, rue Geiler**
**F-67000 Strasbourg(FR)**
Inventeur: **Fuchs, Claude**
**9, rue Mozart**
**F-67450 Mundolsheim(FR)**

(74) Mandataire: **Weinmiller, Jürgen**
**Lennéstrasse 9 Postfach 24**
**W-8133 Feldafing(DE)**

(54) **Méthode permettant de déposer une couche mince à plusieurs corps par photo-ablation.**

(57) L'invention se réfère à une méthode permettant de déposer une couche mince d'au moins deux corps sur un substrat, à l'aide d'une photo-ablation obtenue en irradiant des cibles des corps respectifs par des faisceaux laser pulsés. Selon l'invention, on prévoit autant de faisceaux laser qu'il y a de corps de cibles, la puissance de ces faisceaux étant commandable individuellement en fonction d'une analyse spectrale en temps réel du panache d'ablation s'établissant entre les cibles et le substrat.

EP 0 499 805 A1

L'invention concerne une méthode permettant de déposer une couche mince d'au moins deux corps sur un substrat ou des multicouches de composition différente par photo-ablation obtenue en irradiant des cibles des corps respectifs par des faisceaux laser pulsés.

La technique de photo-ablation par un laser pulsé est utilisée dans la fabrication des semiconducteurs pour produire des dépôts métalliques, semiconducteurs ou isolants sur des substrats quelconques. La méthode est mise en oeuvre dans une enceinte sous vide dans laquelle on place en regard l'un de l'autre une cible de la matière à déposer et un substrat qui doit recevoir ce dépôt. Un faisceau pulsé d'un laser de puissance est dirigé et focalisé sur la cible. Dans des conditions bien définies il en résulte une émission de particules formant un panache. Une partie des particules du panache se dépose alors sur le substrat.

Il est difficile de maîtriser cette méthode et d'obtenir toujours une couche selon des spécifications requises, car il est nécessaire d'optimiser un grand nombre de paramètres qui dépendent de la nature du matériau à déposer, des caractéristiques du faisceau laser (intensité, longueur d'onde, profil spatial et temporel), de la température du substrat et de la configuration des éléments contenus dans l'enceinte. De plus, certains de ces paramètres varient avec le temps, tels que par exemple l'état de surface de la cible après une irradiation prolongée. On obtient donc des résultats d'une qualité très variable et un pourcentage élevé d'échantillons qui ne répondent pas aux spécifications et doivent être rejetés.

Ci-après on entend par le terme "corps" tout matériau se présentant sous forme d'une cible solide, qu'il soit un élément simple ou un corps composé. Ainsi, on veut par exemple déposer sur un substrat d'une part du silicium et d'autre part un métal. S'il est déjà très difficile d'assurer un résultat reproductible et satisfaisant lorsqu'on dépose un seul corps, un dépôt combiné de deux ou plusieurs corps s'avère encore plus compliqué si l'on ne veut pas dépasser un taux de rejet insupportable.

Un tel dépot constitué de deux corps a été fait jusqu'ici en utilisant une cible tournante. La cible, dans ce cas, est un disque circulaire dont un secteur est constitué par le second corps. Le disque est mis en rotation autour d'un axe perpendiculaire à sa surface et passant par son centre, et le faisceau laser est dirigé excentriquement sur cette surface. Il frappe donc par moments le premier corps et par moments le second. La composition de la couche déposée sur le substrat dépend donc de la taille relative des deux secteurs sur la cible, de la vitesse de rotation de celle-ci et de la nature des deux corps. Dans cette configuration, les dépôts obtenus sont constitués d'un empilement régulier de couches différentes, mais en aucun cas d'un film homogène de composition bien définie.

Le but de la présente invention est de proposer une méthode permettant de déposer une couche mince d'au moins deux corps sur un substrat à l'aide d'une photo-ablation obtenue en irradiant par des faisceaux laser pulsés des cibles constituées des corps respectifs, cette méthode assurant un résultat très reproductible et par conséquent un taux de rejet très faible.

Pour atteindre cet objectif, l'invention consiste en l'utilisation d'autant de faisceaux laser qu'il y a de corps de cibles, la puissance de ces faisceaux étant commandable individuellement en fonction d'une analyse spectrale en temps réel du panache d'ablation s'établissant entre les cibles et le substrat.

En ce qui concerne des caractéristiques préférées de cette méthode, référence est faite aux sous-revendications.

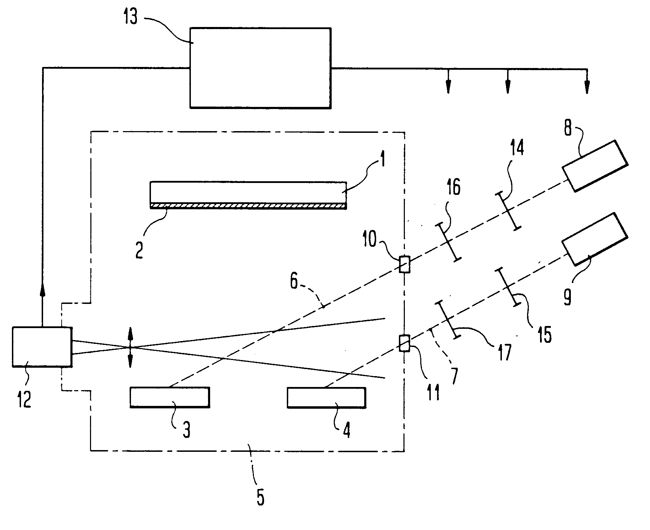

L'invention sera décrite ci-après plus en détail à l'aide d'une mise en oeuvre préférée et du dessin annexé dont la figure unique montre schématiquement cette méthode.

Sur cette figure, on voit un substrat 1 qui doit recevoir le dépôt d'une couche mince 2 sur l'une de ses faces principales. Cette face est en regard de deux cibles 3 et 4 constituées chacune d'un des deux corps dont la couche 2 doit se composer. Les deux cibles et le substrat sont contenus dans une enceinte 5, qui est constamment mise sous vide à l'aide d'un système de pompage (non représenté).

Chacune des cibles est frappée par le faisceau 6 et 7 respectivement d'un laser 8 et 9 respectivement traversant une fenêtre 10 et 11 dans la paroi de l'enceinte 5. Le laser est un laser de puissance, par exemple du type Nd-YAG. Il est susceptible de créer des impulsions d'une durée de quelques dizaines de nanosecondes à une cadence de 30 kHz. Par des moyens optiques non représentés le faisceau est focalisé sur la surface de la cible correspondante afin d'atteindre des densités d'énergie d'environ $10^8$ Watt/cm$^2$. La matière éjectée de la cible fond aussitôt et se vaporise. Les atomes ou molécules vaporisés sont excités ou ionisés. La lumière de recombinaison du plasma est visible. Cette lumière est analysée par un analyseur spectral 12 dont le champ optique couvre le panache évaporé en face des cibles 3 et 4. De préférence, on utilise un analyseur permettant d'effectuer in situ une analyse spatiale et temporelle du panache. Il fournit des signaux significatifs de cette analyse à un dispositif de contrôle 13. Ce dernier optimise en temps réel les paramètres des deux faisceaux laser en vue de rapprocher le panache d'atomes ou molécules évaporés des critères optimaux pour le dépôt recherché. Cette optimisation concerne en premier lieu la puissance des deux générateurs 8 et 9. Puis, on peut varier la durée, la cadence et le rapport de phase des impulsions en tenant compte des différences du temps de vol des deux corps. Enfin, on peut agir sur des atténuateurs 14 et 15 qui sont insérés dans le chemin des deux lasers.

Il est utile d'insérer également dans le trajet de chaque faisceau un obturateur 16 et 17 pour pouvoir mesurer l'effet de chaque laser individuellement en vue de l'étalonnage du système.

Dans le cadre de l'invention, il est aussi utile de prévoir des dispositifs mécaniques pour entraîner en un mouvement de va-et-vient ou de rotation les deux cibles 3 et 4 en vue d'une meilleure répartition des produits d'ablation de leurs surfaces. De même, il est utile de faire tourner le substrat, ce qui uniformise la couche 2.

Dans le cadre de l'invention, il est aussi possible de n'utiliser qu'un seul générateur laser et d'en extraire deux faisceaux par un doubleur de fréquence ou un autre diviseur de faisceau.

La représentation du système sur la figure n'étant que très schématique, il est clair qu'il vaut mieux effectuer l'analyse du panache dans un plan qui ne coincide pas avec celui des deux faisceaux, donc par exemple dans une direction perpendiculaire au plan du dessin.

La méthode n'est pas non plus limitée au dépôt combiné de deux corps, c'est-à-dire à deux cibles telles que les cibles 3 et 4, mais elle peut être étendue à un dépôt constitué de plusieurs corps.

Grâce à la méthode selon l'invention, les conditions de dépôt sont optimisées en continu pendant toute la durée de l'opération et peuvent donc même tenir compte des phénomènes perturbateurs passagers. Il est en outre possible avec la méthode décrite de modifier volontairement la composition du dépôt pendant l'opération.

**Revendications**

1. Méthode permettant de déposer une couche mince d'au moins deux corps sur un substrat, à l'aide d'une photo-ablation obtenue en irradiant des cibles des corps respectifs par des faisceaux laser pulsés, caractérisée par le fait qu'on prévoit autant de faisceaux laser qu'il y a de corps de cibles, la puissance de ces faisceaux étant commandable individuellement en fonction d'une analyse spectrale du panache d'ablation s'établissant entre les cibles et le substrat.

2. Méthode selon la revendication 1, caractérisée en ce qu'on commande, en plus, les instants des impulsions des lasers (8, 9) en considération des temps de vol des corps entre la cible respective et le substrat.

3. Méthode selon l'une des revendications 1 à 2, caractérisée en ce que l'analyse spectrale du panache d'ablation s'établissant entre les cibles et le substrat est une analyse spatiale et/ou temporelle en temps réel.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | WO-A-8 910 427 (BOARD OF REGENTS, THE UNIVERSITY OF TEXAS SYSTEM) <br> * revendications 15,27,31,32 * <br> --- | 1-3 | C23C14/28 <br> C23C14/54 |
| Y | APPLIED PHYSICS LETTERS <br> vol. 53, no. 26, 26 Décembre 1988, NEW YORK, US pages 2701 - 2703; <br> C.H. CHEN ET AL.: 'REAL-TIME MONITORING OF LASER ABLATION DEPOSITION OF SUPERCONDUCTORS BY FLUORESCENCE AND SECONDARY- ION SPECTRA' <br> *EN ENTIER* <br> --- | 1-3 | |
| A | EP-A-0 299 752 (BOC GROUP) <br><br> ----- | | |

**DOMAINES TECHNIQUES RECHERCHES (Int. Cl.5 )**

C23C

Le présent rapport a été établi pour toutes les revendications

| Lieu de la recherche | Date d'achèvement de la recherche | Examinateur |
|---|---|---|
| LA HAYE | 14 AVRIL 1992 | PATTERSON A.M. |

EPO FORM 1503 03.82 (P0402)